# EUROPEAN PATENT APPLICATION

(11) **EP 2 387 079 A2**
(43) Date of publication of application: **16.11.2011**
(21) Application number: 11165103.0
(22) Date of filing: 06.05.2011
(51) Int. Cl.: H01L 31/0224

(54) **Solar cell with metal grid**

(30) Priority: 14.05.2010 US 334579 P; 13.07.2010 US 835670
(71) Applicant: Sierra Solar Power, Inc., Fremont, California 94538 (US)
(72) Inventor: Heng, Jiunn Benjamin, San Jose, CA 95134 (US); Yu, Chentao, Sunnyvale, CA 94087 (US); Xu, Zheng, Pleasanton, CA 94583 (US); Fu, Jianming, Palo Alto, CA 94303 (US)
(74) Representative: Davies, Simon Robert

(57) **Abstract**

One embodiment of the present invention provides a solar cell. The solar cell includes a photovoltaic structure, a transparent-conductive-oxide (TCO) layer situated above the photovoltaic structure, and a front-side metal grid situated above the TCO layer. The TCO layer is in contact with the front surface of the photovoltaic structure. The metal grid includes at least one of: Cu and Ni.

## Description

### Field of the Invention

This disclosure is generally related to solar cells. More specifically, this disclosure is related to a solar cell that includes a metal grid.

### Background of the Invention

The negative environmental impact caused by the use of fossil fuels and their rising cost have resulted in a dire need for cleaner, cheaper alternative energy sources. Among different forms of alternative energy sources, solar power has been favored for its cleanness and wide availability.

A solar cell converts light into electricity using the photovoltaic effect. There are several basic solar cell structures, including a single p-n junction solar cell, a p-i-n/n-i-p solar cell, and a multi-junction solar cell. A typical single p-n junction structure includes a p-type doped layer and an n-type doped layer. Solar cells with a single p-n junction can be homojunction solar cells or heterojunction solar cells. If both the p-doped and n-doped layers are made of similar materials (materials with equal bandgaps), the solar cell is called a homojunction solar cell. In contrast, a heterojunction solar cell includes at least two layers of materials of different bandgaps. A p-i-n/n-i-p structure includes a p-type doped layer, an n-type doped layer, and an intrinsic (undoped) semiconductor layer (the i-layer) sandwiched between the p-layer and the n-layer. A multi-junction structure includes multiple single-junction structures of different bandgaps stacked on top of one another.

In a solar cell, light is absorbed near the p-n junction, generating carriers. The carriers diffuse into the p-n junction and are separated by the built-in electric field, thus producing an electrical current across the device and external circuitry. An important metric in determining a solar cell's quality is its energy-conversion efficiency, which is defined as the ratio between power converted (from absorbed light to electrical energy) and power collected when the solar cell is connected to an electrical circuit.

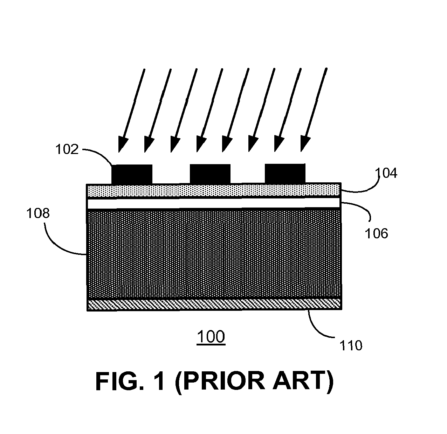

FIG. 1 presents a diagram illustrating an example homojunction solar cell based on a crystalline-Si (c-Si) substrate (prior art). Solar cell 100 includes a front-side Ag electrode grid 102, an anti-reflection layer 104, a c-Si based emitter layer 106, a p-type c-Si substrate 108, and an aluminum (Al) back-side electrode 110. Arrows in FIG. 1 indicate incident sunlight.

In conventional c-Si based solar cells, the current is collected by front-side Ag grid 102. To form Ag grid 102, conventional methods involve printing Ag paste onto the wafers and then firing the Ag paste at a temperature between 700°C and 800°C. The high-temperature firing of the Ag paste ensures good contact between Ag and Si, and low resistivity of the Ag lines.

Many newly developed solar cells are based on amorphous Si (a-Si), which can be used to form a heterojunction with the c-Si layer, or to provide surface passivation for the emitter. The existence of an a-Si layer prevents the solar cell from undergoing high-temperature firing of the Ag paste. To avoid the crystallization of the a-Si layer, and to maintain the passivation effect, the metallization temperature needs to be less than 200°C. One approach is to apply low-temperature Ag paste, which can be cured at a temperature below 200°C. However, the resistivity of the Ag paste cured at the low temperature is usually five to ten times higher than the one cured at a higher temperature. Hence, such an approach can result in high series resistance of the Ag grid which, in turn, results in lower solar cell efficiency. Printing the Ag grid with larger cross sections (thicker Ag layer) can decrease the series resistance. However, such an approach requires multiple printing steps, thus not only adding production complexity, but also requiring the consumption of a larger amount of Ag, which is expensive.

### Summary of the Invention

One embodiment of the present invention provides a solar cell. The solar cell includes a photovoltaic structure, a transparent-conductive-oxide (TCO) layer situated above the photovoltaic structure, and a front-side metal grid situated above the TCO layer. The TCO layer is in contact with the front surface of the photovoltaic structure. The metal grid includes at least one of: Cu and Ni.

In one embodiment, the photovoltaic structure includes at least one of: a homogeneous junction, a heterojunction, a heterotunneling junction, and multiple p-n junctions.

In one embodiment, the resistivity of the front-side metal layer is less than 2 × 10⁻⁵ Ω · *cm.*

In one embodiment, the front-side metal grid further comprises one or more of: a layer of Sn and a layer of Ag. The Ag or Sn layer can cover the top and/or the sidewalls of a Cu line.

In one embodiment, the front-side metal grid is formed using an electroplating technique.

In one embodiment, the TCO layer comprises at least one of: indium-tin-oxide (ITO), aluminum-doped zinc-oxide (ZnO:Al), gallium-doped zinc-oxide (ZnO:Ga), tungsten-doped indium oxide (IWO), and Zn-In-Sn-O (ZITO).

In one embodiment, the photovoltaic structure includes at least one of: a layer of heavily doped amorphous Si (a-Si), a layer of intrinsic a-Si, an a-Si layer with graded doping, and a layer of silicon oxide in contact with a crystalline silicon (c-Si) substrate.

In one embodiment, the solar cell further comprises a back-side electrode which includes a metal grid which can be connected lines or a continuous layer.

In one embodiment, the back-side metal grid is formed using at least one of the following techniques: screen-printing, electroplating, physical vapor deposition including evaporation and sputtering deposition, and aerosol-jet printing.

In one embodiment, the solar cell further includes a back-side TCO layer situated on the back side of the photovoltaic structure and a back-side metal grid situated on the back-side TCO layer. The back-side TCO layer is in contact with the back surface of the photovoltaic structure, and the metal grid includes at least one of: Cu and Ni.

In one embodiment, the solar cell further includes a metal adhesive layer situated between the back-side TCO layer and the back-side metal grid, wherein the metal-adhesive layer includes at least one of: Cu, Ni, Ag, Ti, Ta, W, NiV, TiN, TaN, WN, TiW, and NiCr.

In one embodiment, the solar cell further includes a metal-adhesive layer situated between the TCO layer and the front-side metal grid.

In one embodiment, the metal-adhesive layer includes at least one of: Cu, Ni, Ag, Ti, Ta, W, NiV, TiN, TaN, WN, TiW, and NiCr.

### Brief Description of the Drawings

Various embodiments of the invention are now described in detail by way of example only with reference to the following drawings.

FIG. 1 presents a diagram illustrating an example homojunction solar cell based on a crystalline-Si substrate (prior art).

FIG. 2 presents a diagram illustrating an example process of fabricating a solar cell in accordance with an embodiment of the present invention.

FIG. 3 presents a diagram illustrating an example process of fabricating a solar cell in accordance with an embodiment of the present invention.

In the figures, like reference numerals refer to the same figure elements.

### Detailed Description

The following description is presented to enable any person skilled in the art to make and use the embodiments, and is provided in the context of a particular application and its requirements. Various modifications to the disclosed embodiments will be readily apparent to those skilled in the art, and the general principles defined herein may be applied to other embodiments and applications without departing from the scope of the invention as defined by the appended claims.

### Overview

Embodiments of the present invention provide a solar cell that includes a metal grid formed (fabricated) by electroplating. The solar cell includes an n-type crystalline-Si (c-Si) substrate, an amorphous-Si (a-Si) layer stack including a p-type doped emitter layer and a passivation layer, a transparent-conductive-oxide (TCO) layer, and front- and back-side electrode metal grids. The front-side metal grid is formed by electroplating a metal stack, which can be a single-layer or a multi-layer structure. The back-side electrode is formed by screen-printing, electroplating, or aerosol-jet printing of a metal grid.

### Fabrication Process

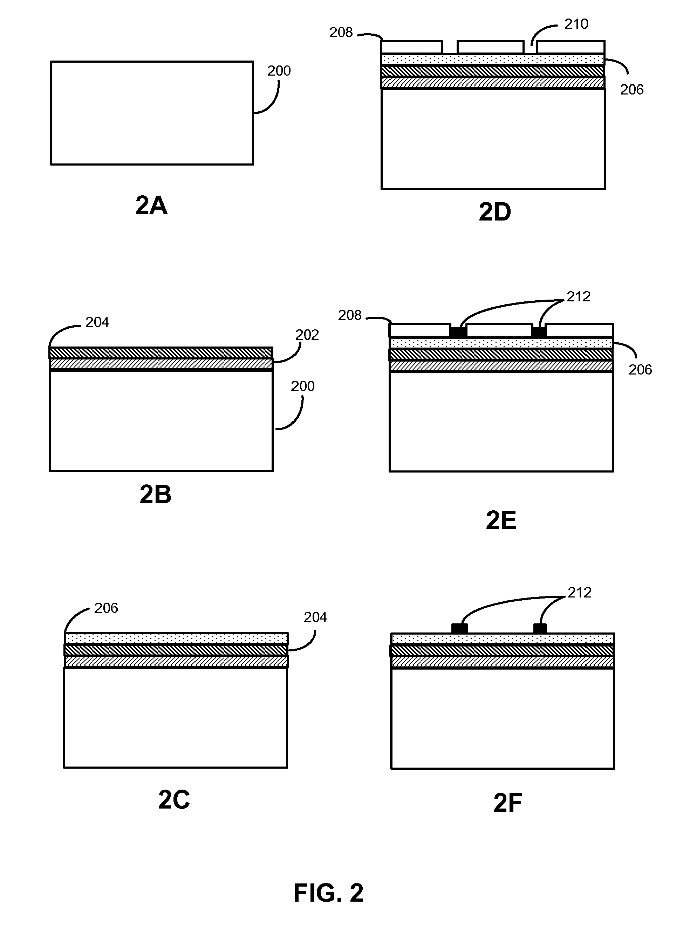

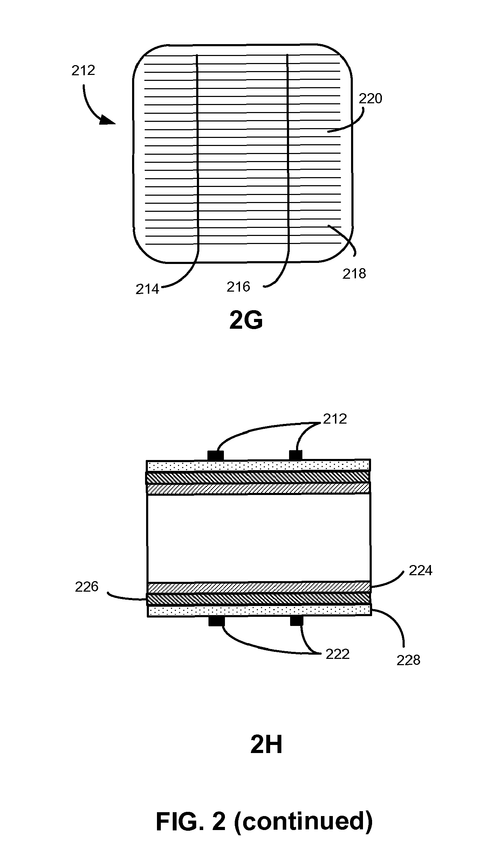

FIG. 2 presents a diagram illustrating an example process of fabricating a solar cell in accordance with an embodiment of the present invention.

In operation 2A, a Si substrate 200 is prepared. In one embodiment, Si substrate 200 can be a crystalline-Si (c-Si) substrate.

In operation 2B, a silicon oxide layer 202 is grown on c-Si substrate 200 to form a passivation layer, and an amorphous Si (a-Si) layer 204 with graded doping is deposited on silicon oxide layer 202 to form an emitter. Depending on the doping type of c-Si substrate 200s, a-Si layer 204 can be either n-type doped or p-type doped. In one embodiment, part of the front a-Si layer 204 is heavily doped with p-type dopants. The highest doping concentration of can be between 1x10¹⁷ /cm³ and 1x10²⁰ /cm³. The thickness of a-Si layer 204 can be between 10 nm and 50 nm, and the thickness of oxide layer 202 can be between 0.5 nm and 2 nm. These form a hetero-tunneling junction as carriers tunnel through the thin oxide. Amorphous-Si layer 204 can be deposited using plasma-enhanced chemical vapor deposition (PECVD). Even though a-Si layer 204 has higher absorption coefficient due to its direct band gap, because the thickness of a-Si layer 204 can be much smaller compared with that of the emitter layer in a homojunction solar cell, the absorption of short wavelength light is significantly reduced, thus leading to higher solar cell efficiency. Note that Si substrate 200, oxide layer 202, and a-Si 204 make up the basic building blocks of a photovoltaic structure. Depending on the material selected to form the different layers, the photovoltaic structure can include at least one of: a homogeneous junction, a heterojunction, a heterotunneling junction, or multiple p-n junctions.

In operation 2C, a layer of transparent-conductive-oxide (TCO) is deposited on top of a-Si layer 204 to form an anti-reflection layer 206 and electrical conduction layer for collecting current. Examples of TCO include, but are not limited to: indium-tin-oxide (ITO), aluminum-doped zinc-oxide (ZnO:Al), gallium-doped zinc-oxide (ZnO:Ga), tungsten-doped indium oxide (IWO), and a Zn-in-Sn-O (ZITO). Techniques used for forming anti-reflection layer 206 include, but are not limited to: PECVD, sputtering, and e-beam evaporation. In addition to depositing a layer of TCO material on the front side of the wafer as TCO layer 206, it is also possible to deposit a TCO layer on both sides of the wafer. In one embodiment, a TCO layer is deposited on the front side, the back side, and the vertical bevel on the edge of the wafer.

In operation 2D, a patterned masking layer 208 is deposited on top of TCO layer 206. The openings of masking layer 208, such as opening 210, correspond to the locations of a designed front metal grid. Masking layer 208 can include a patterned photo resist layer, which can be formed using a photolithography technique. In one embodiment, the photo resist layer is formed by screen-printing resist on top of the wafer. The photo resist is then baked to remove solvent. A mask is laid on the photo resist, and the wafer is exposed to UV light. After the UV exposure, the mask is removed, and the photo resist is developed in a photo resist developer. Opening 210 is formed after develop. The photo resist can also be applied by spraying, dip coating, or curtain coating. Dry fihn resist can also be used. Alternatively, masking layer 208 can include a layer of patterned silicon oxide (SiO₂). In one embodiment, masking layer 208 is formed by first depositing a layer of SiO₂ using a low-temperature plasma-enhanced chemical-vapor-deposition (PECVD) technique. In a further embodiment, masking layer 208 is formed by dip-coating the front surface of the wafer using silica slurry, followed by screen-printing an etchant that includes hydrofluoric acid or fluorides. Other masking materials are also possible, as long as the masking material is electrically insulating.

In operation 2E, one or more layers of metals are deposited at the openings of masking layer 208 to form a metal grid 212. Metal grid 212 can be formed using an electroplating technique, which can include electrodeposition and/or electroless deposition. In one embodiment, TCO layer 206 is coupled to the cathode of the plating power supply, which can be a direct current (DC) power supply, via an electrode. TCO layer 206 and masking layer 208, which includes the openings, are submerged in an electrolyte solution which permits the flow of electricity. Note that, because only the openings within masking layer 208 are electrically conductive, metals will be selectively deposited into the openings, thus forming a metal grid with a designed pattern. Metal grid 212 can be a single layer structure, such as a single layer of Cu or Ag; or a multilayer structure, such as a Ni/Cu bi-layer structure, a Cu/Sn bi-layer structure, a Ni/Cu/Sn tri-layer structure, and a Ni/Cu/Ag tri-layer structure. The sidewalls and top of metal grid 212 can also be coated with Ag or Sn. When a layer of Cu is deposited, a Cu plate is used at the anode, and the solar cell is submerged in the electrolyte suitable for Cu plating. The current used for Cu plating is between 0.1 Ampere and 2 Ampere for a wafer with a dimension of 125 mm × 125 mm, and the thickness of the Cu layer is approximately tens of micrometers. The deposition of a Ni layer can also be an electroplating process, during which a Ni plate is used at the anode, and the solar cell is submerged in the electrolyte suitable for Ni plating. The voltage used for Ni plating can be between 1 V and 3 V. In cases where the back side of the wafer is also covered with a layer of TCO, the cathode of the plating power supply can be coupled to the TCO layer on the back side of the wafer, and the whole wafer is submerged in the electrolyte solution. The cathode can also be directly in contact with the front side by using contact pins at the openings of masking layer 208. Metal stacks deposited using the electroplating technique often have lower resistivity compared with low-temperature-cured silver paste layers. In one embodiment, the resistivity of metal grid 212 is less than 2 × 10⁻⁵ Ω · *cm .* In a further embodiment, the resistivity of metal grid 212 is equal to or less than 5 × 10⁻⁶ Ω · *cm .* In contrast, Ag paste cured at 200°C often has a resistivity greater than 2 × 10⁻⁵ Ω · *cm .* The lower resistivity of the metal grid can significantly enhance solar cell efficiency.

In operation 2F, masking layer 208 is removed. As a result, front-side electrode grid (metal grid) 212 is completed with the designed pattern and line width. FIG. 2G illustrates the top view of an example front-side electrode grid 212 in accordance with an embodiment of the present invention. Front-side electrode grid 212 includes busbars, such as busbars 214 and 216, and fingers, such as fingers 218 and 220. Busbars are thicker metal strips connected directly to the external leads, and fingers are finer metal strips that collect current for delivery to the busbars.

In operation 2H, back-side oxide layer 224, back-side a-Si layer 226, and back-side TCO layer 228 are formed using the methods described in operation 2A through 2C. In addition, back-side electrode grid 222 is formed on the back-side TCO layer 228. Back-side electrode grid 222 can be formed using the same electroplating method as the one used for forming front-side electrode grid 212. The backside grid could be different from front side in densities, or in blanket.

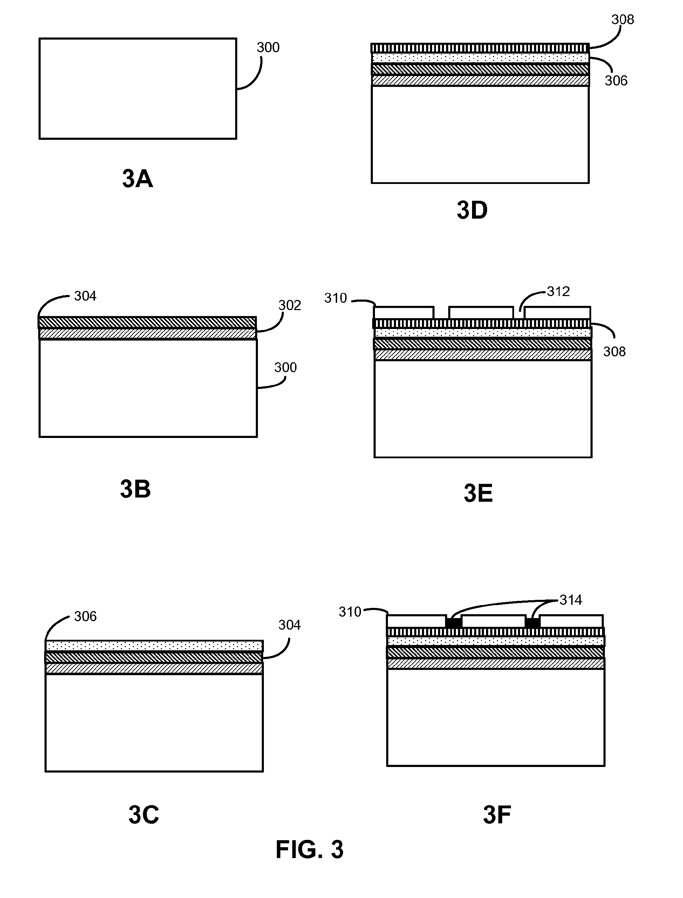

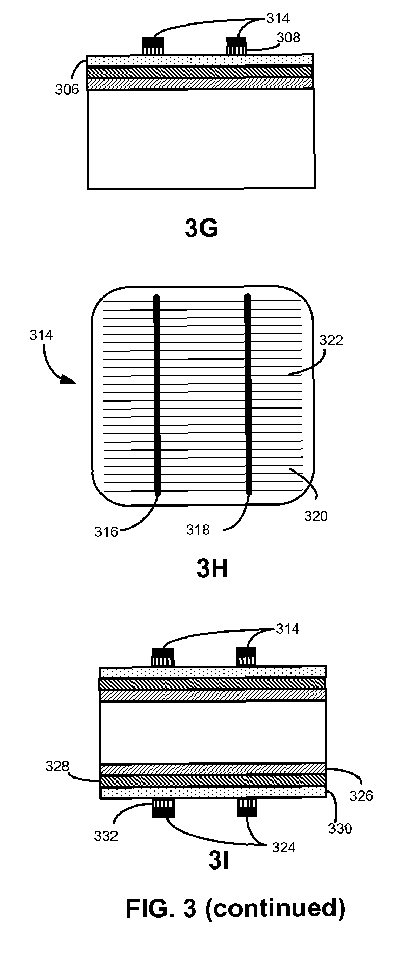

FIG. 3 presents a diagram illustrating another example process of fabricating a solar cell in accordance with an embodiment of the present invention.

In operation 3A, a Si substrate 300 is prepared. The process used for preparing Si substrate 300 is similar to the one used in operation 2A.

In operation 3B, an oxide layer 302 is grown on Si substrate 300 to form a passivation layer, and an a-Si layer 304 with graded doping is deposited on oxide layer 302 to form an emitter. The deposition technique used for depositing layers 304 and 302 is similar to the one used in operation 2B.

In operation 3C, a layer of TCO material is deposited on top of a-Si layer 304 to form an anti-reflection layer 306. The formation process of anti-reflection layer (or TCO layer) 306 is similar to the one used in operation 2C.

In operation 3D, a thin metal layer 308 is deposited on top of TCO layer 306. Thin metal layer 308 can be deposited using a physical vapor deposition (PVD) technique, such as sputtering deposition or evaporation. Thin metal layer 308 can include Cu, Ni, Ag, NiV, Ti, Ta, W, TiN, TaN, WN, TiW, NiCr, and their combinations. Forming thin metal layer 308 on top of TCO layer 306 improves the adhesion between TCO layer 306 and the subsequently deposited front-side metal grid.

In operation 3E, a patterned masking layer 310 is deposited on top of thin-metal layer 308 using a process similar to the one used in operation 2D. The openings of masking layer 310, such as opening 312, correspond to the locations of a designed front-side metal grid.

In operation 3F, one or more layers of metals are deposited at the openings of masking layer 310 to form a metal grid 314 using materials and processes similar to the ones used in operation 2E.

In operation 3G, masking layer 310 and portions of thin metal layer 308 are removed to expose the portions of TCO layer 306 not covered by metal grid 314. As a result, front-side electrode grid (metal grid) 314 is completed with the designed pattern and line width. If thin metal layer 308 is transparent, then operation 3G can only remove masking layer 310. In one embodiment, thin metal layer 308 includes an ultrathin NiCr layer, which is transparent and remains intact after operation 3G.

FIG. 3H illustrates an example top view of front-side electrode grid 314 in accordance with an embodiment of the present invention. Front-side electrode grid 314 includes busbars, such as busbars 316 and 318, and fingers, such as fingers 320 and 322. Busbars are thicker metal strips connected directly to the external leads, and fingers are finer metal strips that collect current for delivery to the busbars.

In operation 3I, back-side oxide layer 326, back-side a-Si layer 328, back-side TCO layer 330, adhesive metal layer 332, and back-side electrode grid 324 are formed on the back side of the wafer using a process that is similar to the one used in operations 3B through 3G.

The foregoing descriptions of various embodiments have been presented only for purposes of illustration and description. They are not intended to be exhaustive or to limit the present invention to the forms disclosed. Accordingly, many modifications and variations will be apparent to practitioners skilled in the art. Additionally, the above disclosure is not intended to limit the present invention.

Further embodiments of the invention are defined in the following numbered clauses:
1. A solar cell, comprising:
   a photovoltaic structure;
   a transparent-conductive-oxide (TCO) layer situated above the photovoltaic structure, wherein the TCO layer is in contact with the front surface of the photovoltaic structure; and
   a front-side metal grid situated above the TCO layer, wherein the metal grid includes at least one of: Cu and Ni.
2. The solar cell of clause 1, wherein the photovoltaic structure includes at least one of:
   a homogeneous junction;
   a heterojunction;
   a heterotunneling junction; and
   multiple p-n junctions.
3. The solar cell of clause 1, wherein the resistivity of the front-side metal grid is less than 2 × 10⁻⁵ Ω · *cm.*
4. The solar cell of clause 1, wherein the front-side metal grid further comprises one or more of: Sn and Ag.
5. The solar cell of clause 1, wherein the front-side metal grid is formed using an electroplating technique.
6. The solar cell of clause 1, wherein the TCO layer comprises at least one of:
   indium-tin-oxide (ITO);
   aluminum-doped zinc-oxide (ZnO:Al);
   gallium-doped zinc-oxide (ZnO:Ga);
   tungsten-doped indium oxide (IWO); and
   Zn-In-Sn-O (ZITO).
7. The solar cell of clause 1, wherein the photovoltaic structure includes at least one of:
   a layer of heavily doped amorphous-Si (a-Si);
   a layer of intrinsic a-Si;
   an a-Si layer with graded doping; and
   a layer of silicon oxide in contact with a crystalline silicon (c-Si) substrate.
8. The solar cell of clause 1, further comprising a back-side electrode which includes a metal grid which can be connected lines or a continuous layer.
9. The solar cell of clause 8, wherein the back-side metal grid is formed using at least one of the following techniques:
   screen-printing;
   electroplating;
   physical vapor deposition including evaporation and sputtering deposition; and
   aerosol-jet printing.
10. The solar cell of clause 1, further comprising:
   a back-side TCO layer situated on the back side of the photovoltaic structure, wherein the back-side TCO layer is in contact with the back surface of the photovoltaic structure; and
   a back-side metal grid situated on the back-side TCO layer, wherein the metal grid includes at least one of: Cu and Ni.
11. The solar cell of clause 10, further comprising a metal-adhesive layer situated between the back-side TCO layer and the back-side metal grid, wherein the metal-adhesive layer includes at least one of: Cu, Ni, Ag, Ti, Ta, W, NiV, TiN, TaN, WN, TiW, and NiCr.
12. The solar cell of clause 1, further comprising a metal-adhesive layer situated between the TCO layer and the front-side metal grid.
13. The solar cell of clause 12, wherein the metal-adhesive layer includes at least one of:
   Cu, Ni, Ag, Ti, Ta, W, NiV, TiN, TaN, WN, TiW, and NiCr.
14. A method for fabricating a solar cell, comprising:
   depositing one or more layers of amorphous-Si (a-Si) on top of a crystalline Si (c-Si) substrate with thin oxide formed on the surface to form a photovoltaic structure;
   depositing a layer of transparent-conductive-oxide (TCO) on top of the a-Si layers;
   forming a front-side electrode grid comprising a metal stack on top of the TCO layer, wherein the metal stack includes at least one of: a layer of Cu and a layer ofNi; and
   forming a back-side electrode on the back side of the Si substrate.
15. The method of clause 14, wherein the a-Si layers includes at least one of:
   a layer of heavily doped a-Si;
   a layer of intrinsic a-Si; and
   an a-Si layer with graded doping.
16. The method of clause 14, wherein the resistivity of the front-side electrode grid is less than 2 × 10⁻⁵ Ω · *cm.*
17. The method of clause 14, wherein the metal stack further comprises one or more of:
   a layer of Sn; and
   a layer of Ag.
18. The method of clause 14, wherein forming the front-side electrode grid involves electroplating the metal stack on top of the TCO layer.
19. The method of clause 18, wherein forming the front-side electrode grid further involves depositing and/or removing a patterned masking layer on top of the TCO layer.
20. The method of clause 14, wherein the TCO layer comprises at least one of:
   indium-tin-oxide (ITO);
   aluminum-doped zinc-oxide (ZnO:Al);
   gallium-doped zinc-oxide (ZnO:Ga);
   tungsten-doped indium oxide (IWO); and
   Zn-In-Sn-O (ZITO).
21. The method of clause 14, wherein the photovoltaic structure includes at least one of:
   a homogeneous junction;
   a heterojunction;
   a hetero tunneling junction; and
   multiple p-n junctions.
22. The method of clause 21, wherein the c-Si substrate is n-type doped, and wherein the heavily doped a-Si layer and/or the a-Si layer with graded doping are p-type doped.
23. The method of clause 14, wherein the back-side electrode comprises a metal grid which can be connected lines or a continuous layer.
24. The method of clause 23, wherein the back-side metal grid is formed using at least one of the following techniques:
   screen-printing;
   electroplating;
   physical vapor deposition including evaporation and sputtering deposition; and
   aerosol-jet printing.
25. The method of clause 14, further comprising:
   depositing a back-side TCO layer on the back side of the photovoltaic structure,
   wherein the back-side TCO layer is in contact with the back surface of the photovoltaic structure; and
   fabricating a back-side electrode grid on the back-side TCO layer, wherein the back-side electrode grid includes at least one of: Cu and Ni.
26. The method of clause 25, further comprising depositing a metal adhesive layer between the back-side TCO layer and the back-side electrode grid, wherein the metal-adhesive layer includes at least one of: Cu, Ni, Ag, Ti, Ta, W, NiV, TiN, TaN, WN, TiW, and NiCr.
27. The method of clause 14, further comprising depositing a metal-adhesive layer between the TCO layer and the front-side electrode grid.
28. The method of clause 27, wherein the adhesive-metal layer is deposited using a physical vapor deposition technique including one of: evaporation and sputtering deposition.
29. The method of clause 27, wherein the metal-adhesive layer includes at least one of:
   Cu, Ni, Ag, Ti, Ta, W, NiV, TiN, TaN, WN, TiW, and NiCr.

## Claims

1. A solar cell, comprising:
a photovoltaic structure;
a transparent-conductive-oxide (TCO) layer situated above the photovoltaic structure, wherein the TCO layer is in contact with the front surface of the photovoltaic structure; and
a front-side metal grid situated above the TCO layer, wherein the metal grid includes at least one of: Cu and Ni.

2. The solar cell of claim 1, wherein the photovoltaic structure includes at least one of:
a homogeneous junction;
a heterojunction;
a hetero tunneling junction; and
multiple p-n junctions.

3. The solar cell of claim 1 or 2, wherein the resistivity of the front-side metal grid is less than 2 × 10⁻⁵ Ω · *cm.*

4. The solar cell of any preceding claim, wherein the front-side metal grid further comprises one or more of: Sn and Ag.

5. The solar cell of any preceding claim, wherein the front-side metal grid is formed using an electroplating technique.

6. The solar cell of any preceding claim, wherein the TCO layer comprises at least one of:
indium-tin-oxide (ITO);
aluminum-doped zinc-oxide (ZnO:Al);
gallium-doped zinc-oxide (ZnO:Ga);
tungsten-doped indium oxide (IWO); and
Zn-In-Sn-O (ZITO).

7. The solar cell of any preceding claim, wherein the photovoltaic structure includes at least one of:
a layer of heavily doped amorphous-Si (a-Si);
a layer of intrinsic a-Si;
an a-Si layer with graded doping; and
a layer of silicon oxide in contact with a crystalline silicon (c-Si) substrate.

8. The solar cell of any preceding claim, further comprising a back-side electrode which includes a metal grid which can be connected lines or a continuous layer.

9. The solar cell of claim 8, wherein the back-side metal grid is formed using at least one of the following techniques:
screen-printing;
electroplating;
physical vapor deposition including evaporation and sputtering deposition; and
aerosol-jet printing.

10. The solar cell of any preceding claim, further comprising:
a back-side TCO layer situated on the back side of the photovoltaic structure, wherein the back-side TCO layer is in contact with the back surface of the photovoltaic structure; and
a back-side metal grid situated on the back-side TCO layer, wherein the metal grid includes at least one of: Cu and Ni.

11. The solar cell of claim 10, further comprising a metal-adhesive layer situated between the back-side TCO layer and the back-side metal grid, wherein the metal-adhesive layer includes at least one of: Cu, Ni, Ag, Ti, Ta, W, NiV, TiN, TaN, WN, TiW, and NiCr.

12. The solar cell of any preceding claim, further comprising a metal-adhesive layer situated between the TCO layer and the front-side metal grid.

13. The solar cell of claim 12, wherein the metal-adhesive layer includes at least one of:
Cu, Ni, Ag, Ti, Ta, W, NiV, TiN, TaN, WN, TiW, and NiCr.

14. A method for fabricating a solar cell, comprising:
depositing one or more layers of amorphous-Si (a-Si) on top of a crystalline Si (c-Si) substrate with thin oxide formed on the surface to form a photovoltaic structure;
depositing a layer of transparent-conductive-oxide (TCO) on top of the a-Si layers;
forming a front-side electrode grid comprising a metal stack on top of the TCO layer, wherein the metal stack includes at least one of: a layer of Cu and a layer ofNi; and
forming a back-side electrode on the back side of the Si substrate.

15. The method of claim 14, wherein the a-Si layers includes at least one of:
a layer of heavily doped a-Si;
a layer of intrinsic a-Si; and
an a-Si layer with graded doping.
